# EUROPEAN PATENT SPECIFICATION

(11) **EP 3 065 168 B1**
(45) Date of publication and mention of the grant of the patent: **12.08.2020**
(21) Application number: 14856813.2
(22) Date of filing: 30.10.2014
(51) Int. Cl.: H01L 23/15, H01L 23/12, H01L 21/02, H01L 41/09, G06F 1/16, B06B 1/06

(54) **SAPPHIRE STRUCTURE HAVING ATTACHED METAL BODY, METHOD FOR MANUFACTURING SAPPHIRE STRUCTURE HAVING ATTACHED METAL BODY, ELECTRONIC DEVICE, AND OUTER PACKAGE**
SAPHIRSTRUKTUR MIT ANGEHÄNGTEM METALLKÖRPER, VERFAHREN ZUR HERSTELLUNG DER SAPHIRSTRUKTUR MIT ANGEHÄNGTEM METALLKÖRPER, ELEKTRONISCHE VORRICHTUNG UND AUSSENVERPACKUNG
STRUCTURE DE SAPHIR À LAQUELLE EST FIXÉ UN CORPS MÉTALLIQUE, PROCÉDÉ DE FABRICATION DE STRUCTURE DE SAPHIR À LAQUELLE EST FIXÉ UN CORPS MÉTALLIQUE, DISPOSITIF ÉLECTRONIQUE ET BOÎTIER EXTÉRIEUR

(30) Priority: 30.10.2013 JP 2013225829
(43) Date of publication of application: 07.09.2016
(73) Proprietor: Kyocera Corporation, Kyoto-shi, Kyoto 612-8501 (JP)
(72) Inventor: UMEHARA, Motohiro, Kyoto-shi, Kyoto 612-8501 (JP); KUBO, Yoshinori, Kyoto-shi, Kyoto 612-8501 (JP)
(74) Representative: Viering, Jentschura & Partner mbB Patent- und Rechtsanwälte
(86) International application number: PCT/JP2014/078878
(87) International publication number: WO 2015/064682

(56) References cited:
- JP-A- H06 152 103
- JP-A- H06 152 103
- JP-A- H07 106 459
- JP-A- H07 106 459
- JP-A- 2000 344 584
- JP-A- 2002 141 643
- JP-A- 2002 257 659
- JP-A- 2004 053 290
- JP-A- 2004 053 290
- JP-A- 2010 186 842
- JP-A- 2011 066 449
- JP-A- 2011 259 513
- JP-A- 2012 174 053
- JP-A- 2013 193 943
- US-A1- 2012 212 890
- US-B1- 6 590 760
- ZEFANG ZHANG ET AL: "Two-Step Chemical Mechanical Polishing of Sapphire Substrate", JOURNAL OF THE ELECTROCHEMICAL SOCIETY, vol. 157, no. 6, 3 May 2010 (2010-05-03), page H688, XP055377739, US ISSN: 0013-4651, DOI: 10.1149/1.3410116

## Description

### Technical Field

The present invention relates to a sapphire structure with a metal body, a method of producing a sapphire structure with a metal body, an electronic apparatus, and an exterior body.

### Background Art

Since sapphire as a single crystal of alumina has a crystal lattice constant close to that of gallium nitride (GaN) which is a material of an LED element, the sapphire has been widely used as a substrate for gallium nitride crystal growth for creating the LED element. Further, the sapphire has properties of high hardness, resistance to damage, high thermal conductivity, a high light transmission property, a small dielectric loss, or the like in addition to the characteristic of having a crystal lattice constant close to that of gallium nitride so that various devices using these properties of the sapphire have been developed.

For example, Patent Literature 1 described below discloses an example of an eddy current sensor in which a patterned metal layer is provided on a surface of an insulation substrate and describes a sapphire substrate as an example of the insulation substrate.

Document JP 2010 186842 describes a method of forming a wiring conductor including forming a groove on a sapphire substrate and placing a metal conductor into the groove.

Document JP 07106459 describes a method of forming a metalized layer in a sapphire substrate.

Document US 6,590,760 B1 describes a joint structure of a ceramic substrate and metal embedded in groove in the substrate, wherein the inner surface of the groove in the substrate has rounded corners between a bottom surface and a side surface.

Document JP 06152103 describes a method of forming a metal layer on a groove in a substrate, wherein the groove has inverse tapered sides and a roughness of the sides of the metal contacting the groove is controlled.

Patent Literature 1: Japanese Patent Application Publication No. 2012-220494

### SUMMARY OF THE INVENTION

For example, in a device using an electrical signal like the eddy current sensor disclosed in Japanese Unexamined Patent Application Publication No. 2012-220494, it is necessary to form a metal layer on a surface of a sapphire substrate. A metallization technology of forming a metal layer on a surface of a normal ceramic board such as an alumina sintered body has been continuously improved for a long time, and a technology of forming a metal layer on a surface of, for example, a sintered alumina board with high bonding strength has been known. On the other hand, since the technology of forming a metal layer on a surface of a substrate made of sapphire which is a single crystal has not been sufficiently established yet, the bonding strength between sapphire and the metal layer is not sufficient and the metal layer is easily peeled off from the sapphire substrate when the metal layer is formed on the surface of the sapphire substrate as disclosed in Japanese Unexamined Patent Application Publication No. 2012-220494. In addition, when the metal layer is simply formed on the sapphire substrate as disclosed in Japanese Unexamined Patent Application Publication No. 2012-220494, since the metal layer portion protrudes in a form of a convex from the surface of the sapphire substrate, the metal layer protruding in a form of a convex interrupts another member being brought into contact with the surface of the sapphire substrate in a case where another member is brought into contact with the surface of the sapphire substrate, for example, a case of mounting other devices on the sapphire substrate or the like.

Accordingly, the present invention for solving the above-described problems provides a sapphire structure with a metal body according to claim 1 and a method of producing a sapphire structure with a metal body according to claim 12. Further embodiments of the present invention are described in the dependent claims.

In the sapphire structure with a metal body of the present invention, the metal body is difficult to peel off from the sapphire structure and other members can be brought into contact with the surface of the sapphire substrate With relative ease. Further, in the method of producing a sapphire structure with a metal body of the present invention, the sapphire structure with a metal body which is difficult to separate from the sapphire structure can be easily produced with a small number of processes.

### BRIEF DESCRIPTION OF THE DRAWINGS

Figs. 1A and 1B are views describing an embodiment of a sapphire structure with a metal body of the present invention, and Fig. 1A is a schematic perspective view and Fig. 1B is a schematic cross-sectional view;
Fig. 2 is a cross-sectional view illustrating an embodiment of a device configured using the sapphire structure with a metal body illustrated in Figs. 1A and 1B;
Fig. 3 is a partially enlarged view of Fig. 1B;
Fig. 4 is a cross-sectional view corresponding to Fig. 3 illustrating another embodiment of the sapphire structure with a metal body of the present invention;
Fig. 5 is a cross-sectional view illustrating an embodiment of a member with a metal pattern using the sapphire structure with a metal body of the present invention;
Figs. 6A to 6E are cross-sectional views illustrating an embodiment of a method of producing the sapphire structure with a metal body of the present invention;
Fig. 7 is a perspective view illustrating an electronic apparatus configured using an embodiment of the sapphire structure with a metal body;
Fig. 8 is a front view illustrating the electronic apparatus configured using an embodiment of the sapphire structure with a metal body;
Fig. 9 is a rear view illustrating the electronic apparatus configured using an embodiment of the sapphire structure with a metal body;
Fig. 10 is an exploded perspective view illustrating the electronic apparatus configured using an embodiment of the sapphire structure with a metal body;
Fig. 11A is a perspective view illustrating a rear surface side panel and Fig. 11B is a cross-sectional view;
Figs. 12A and 12B are views illustrating another embodiment of a sapphire structure with a metal body, and Fig. 12A is a plan view and Fig. 12B is a cross-sectional view;
Fig. 13 is a block diagram illustrating an electrical configuration of the electronic apparatus;
Fig. 14A is a top view illustrating a configuration of a piezoelectric vibrating element, Fig. 14B is a side view, Figs. 14C and 14D are side views illustrating the piezoelectric vibrating element in a state of being operated; and
Fig. 15 is a view illustrating a structure of an ear of the user of an electronic apparatus.

### DESCRIPTION OF THE PREFERRED EMBODIMENTS

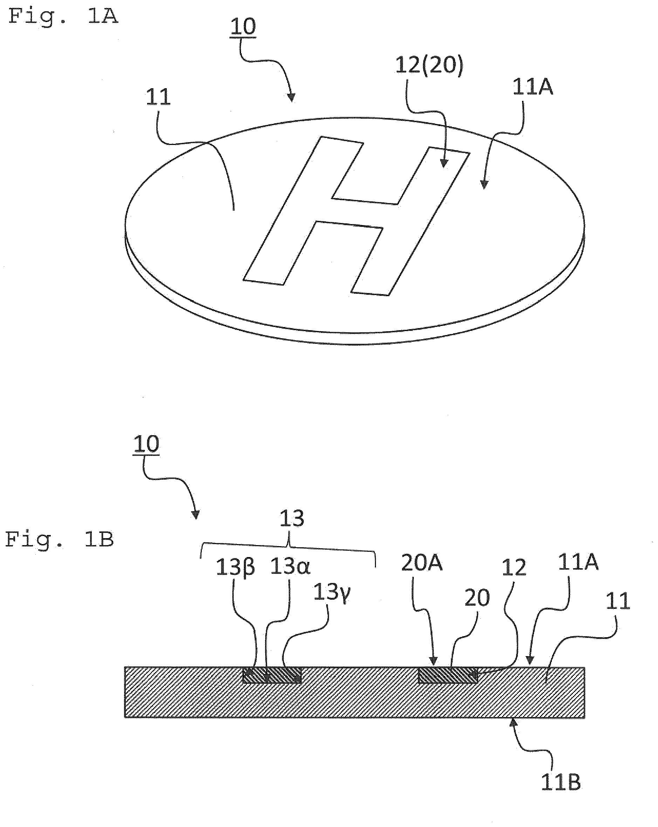

Hereinafter, one embodiment of a sapphire structure with a metal body of the present invention and a method of producing a sapphire structure with a metal body will be described in detail. Figs. 1A and 1B are views describing a sapphire structure 10 with a metal body (hereinafter, also simply referred to as a structure 10 with a metal body) which is an embodiment of the sapphire structure with a metal body of the present invention, and Fig. 1A is a schematic perspective view and Fig. 1B is a schematic cross-sectional view.

The structure 10 with a metal body includes a sapphire structure 11 which includes a flat surface 11A and is provided with a concave portion 12 on the flat surface 11A; and a metal body 20 which is arranged in the concave portion 12 and bonded to an inner surface 13 of the concave portion 12, and the metal body 20 includes a surface portion 20A which is substantially with the flat surface 11A. The sapphire structure 11 is a plate-like body including the flat surface 11A as a first surface and includes a second surface 11B positioned on the opposite side to the flat surface 11A which is the first surface. The sapphire structure 11 is made of sapphire which is a single crystal of aluminum oxide (Al₂O₃) and contains aluminum oxide (Al₂O₃) in the range of 75% by mass or more. It is preferable that the sapphire structure contain aluminum oxide (Al₂O₃) in the range of 95% or more. In addition, the flat surface 11A being substantially with the surface portion 20A of the metal body 20 means that a height difference between the flat surface 11A and the surface portion 20A of the metal body 20 is less than +/-500 µm. The height difference between the flat surface 11A and the surface portion 20A of the metal body 20, is preferably less than +/-100 µm. Further, the height difference thereof is more preferably less than +/-10 µm, still more preferably less than +/-1 µm, and still more preferably less than +/-0.1 µm.

In the present embodiment, the metal body 20 contains silver (Ag) as a main component. Further, the metal body 20 contains copper (Cu) or titanium (Ti). In addition, in the structure 10 with a metal body of the present embodiment, the arithmetic average roughness (Ra) of the surface portion 20A of the metal body 20 which is substantially with the flat surface 11A is greater than that of the flat surface 11A. In addition, the arithmetic average roughness of the flat surface 11A is preferably 10 nm or less and the arithmetic average roughness of the flat surface 11A is more preferably 1 nm or less. In the structure 10 with a metal body, since the metal body 20 is arranged in the concave portion 12 and bonded to the inner surface 13 of the concave portion 12, the metal body 20 is difficult to peel off from the structure 10. Further, as the arithmetic average roughness thereof, a value measured by a measurement method in conformity with JIS standard B0601-2001 may be used.

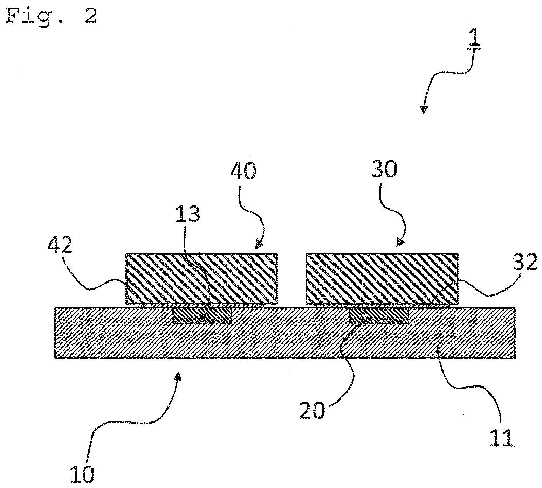

Fig. 2 is a cross-sectional view illustrating an embodiment of a device configured using the structure 10 with a metal body. In the device 1 of the embodiment illustrated in Fig. 2, a first device 30 and a second device 40 are mounted on the structure 10 with a metal body and the first device 30 and the second device 40 are electrically connected using the metal body 20 as an electrical wiring. The first device 30 illustrated in Fig. 2 is, for example, a driving circuit element including an electrode 32 and the second device 40 is, for example, a light emitting device (LED) including an electrode 42. Since the metal body 20 includes the surface portion 20A which is substantially with the flat surface 11A, the first device 30 or the second device 40 can be brought into contact with the structure 10 with a metal body in a state substantially free of gaps or the like caused by a difference between steps by bringing an exterior member such as the first device 30 or the second device 40 into contact with the portion flush with the flat surface 11A in a case where another member such as the first device 30 or the second device 40 is mounted on the structure 10 with a metal body as illustrated in Fig. 2. Since the sapphire structure 11 has high thermal conductivity because the sapphire structure 11 is made of sapphire, heat emitted from the first device 30 or the second device 40 can be efficiently dissipated from the sapphire structure 11 and operational reliability of the first device 30 or the second device 40 can be improved by bringing part of the first device 30 or the second device 40 into contact with the flat surface 11A of the sapphire structure 11 with a small gap. Further, since the light transmission property of the sapphire structure 11 is high, the light emitted from the second device 40 which is a light emitting device (LED) in the device 1 enters the sapphire structure 11 and can be radiated in a wide range on the lower side in Fig. 2. In the device 1, since there is no extra gap between the flat surface 11A of the sapphire structure 11 and the second device 40, a refractive index difference is not present between the sapphire structure 11 and an air layer which is present when there is a gap, and a large amount of light can be radiated to the lower side in Fig. 2 by suppressing extra reflection light. Further, sapphire has small electrical resistance and a dark current flowing over the surface of the sapphire structure 11 is suppressed so as to be small, so operation failure of the first device 30 or the second device 40 mounted on the surface of the sapphire structure 11 caused by the dark current is suppressed. The first device 30 or the second device 40 may be a transmitter or a receiver for transmitting or receiving electromagnetic signals in a wireless manner. Since sapphire has a small dielectric loss, electromagnetic waves can be transmitted or received with a small loss in a wide range in a case where the transmitter or a receiver is mounted on the sapphire structure 11. The kinds of the first device 30 or the second device 40 are not particularly limited, and various devices or apparatuses can be mounted.

Further, the use of the structure 10 with a metal body is not limited to the use of the structure 10 with a metal body by other devices such as the first device 30 or the second device 40 or an apparatus being mounted thereon. The structure 10 with a metal body has a characteristic appearance such that the flat surface 11A of the sapphire structure 11 having a high light transmission property is substantially with the surface portion 20A of the metal body 20 having metallic glossiness. For example, in a case where the structure 10 with a metal body is used for part of a housing which covers a device capable of transmitting and receiving a wireless signal, a transceiving device which has high transmitting and receiving sensitivity of the wireless signal, in which the housing has high strength and is difficult to be broken, and has an excellent designability due to a characteristic appearance can be formed. The structure 10 with a metal body can be used for various purposes.

In the structure 10 with a metal body of the present embodiment, since the arithmetic average roughness (Ra) of the surface portion 20A which is substantially with the flat surface 11A is greater than the arithmetic average roughness (Ra) of the flat surface 11A, the bonding strength between a solder layer or a metallized layer and the surface portion 20A becomes relatively high by an anchor effect due to unevenness of the surface in a case where the first device 30 or the second device 40 is bonded to the surface portion 20A of the metal body 20 through the solder layer or the metallized layer (not illustrated). The metal body 20 is difficult to peel off from the concave portion 12 as described above, and the first device 30 or the second device 40 and the metal body 20 are difficult to peel off from the sapphire structure 11 in a case where the first device 30 or the second device 40 is mounted.

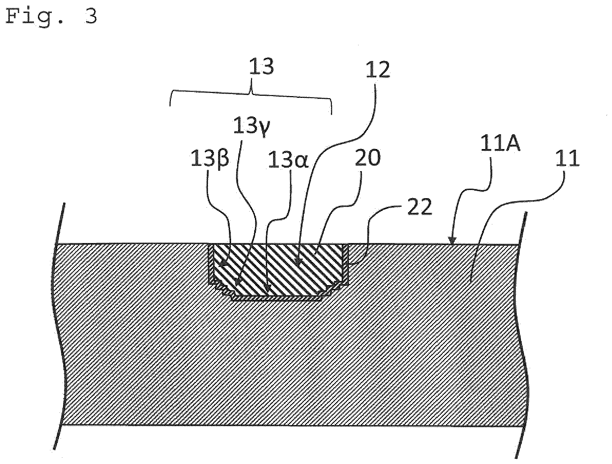

Fig. 3 is a partially enlarged view of Fig. 1B. The metal body 20 of the present embodiment contains silver (Ag) as a main component. The metal body 20 contains silicon dioxide (SiO₂). The bonding strength between the metal body 20 and the sapphire structure 11 becomes relatively strong by the metal body 20 containing silicon dioxide (SiO₂). In addition, the metal body 20 contains copper (Cu) and titanium (Ti). In a case where the structure 10 is used as a wiring board or the like, silver (Ag) is preferable in terms of low electrical resistance and high conductivity. Further, the hardness of the metal body 20 is higher by the metal body 20 containing copper (Cu) when compared to the case where the metal body only contains silver (Ag). In addition, the bonding strength between the metal body 20 and the inner surface 13 of the concave portion 12 becomes relatively high by the metal body 20 containing titanium (Ti). Specifically, as illustrated in Fig. 3, a bonding layer 22 containing titanium (Ti) as a main component is formed in a bonding area in which the metal body 20 is bonded to the inner surface 13, and the metal body 20 and the inner surface 13 are relatively strongly bonded to each other.

Moreover, the inner surface 13 of the concave portion 12 includes a bottom surface 13α, a side surface 13β, and a surface (an inclined surface 13γ) having an inclination to the bottom surface 13α and the side surface 13β which is located between the bottom surface 13α and the side surface 13β. The inclined surface 13γ is connected to the bottom surface 13α and the side surface 13β. The bottom surface 13α is substantially vertical to the side surface 13β. In case the inclined surface 13γ is absent, the corner portion between the bottom surface 13α and the side surface 13β makes a right angle. In case the metal body 20 expand with heat, the corner portion easily generating a stress concentration caused by thermal expansion, and the corner portion is not liable to be the initiation point of the occurrence of breaking such as cracking. In this embodiment having the inclined surface 13γ, the inclined surface 13γ is connected to the bottom surface 13α so as to make an obtuse angle, and the inclined surface 13γ is connected to the side surface 13β so as to make an obtuse angle. In case the metal body 20 expand with heat, the corner portion having an obtuse angle hardly generating a stress concentration caused by thermal expansion. In this embodiment, generating a stress concentration caused by thermal expansion of the metal body 20 and a breaking such as cracking is suppressed.

The inclined surface 13γ is inclined with respect to the bottom surface 13α and the side surface 13β, and has an arithmetic average surface roughness greater than those of the bottom surface 13α and the side surface 13β. Since the arithmetic average surface roughness of the inclined surface 13γ is great, that is, since the unevenness of the surface of inclined surface 13γ is relatively large, the metal body 20 is rigidly bonded to inclined surface 13γ due to the anchor effect and the metal body 20 is difficult to peel off from the concave portion 12.

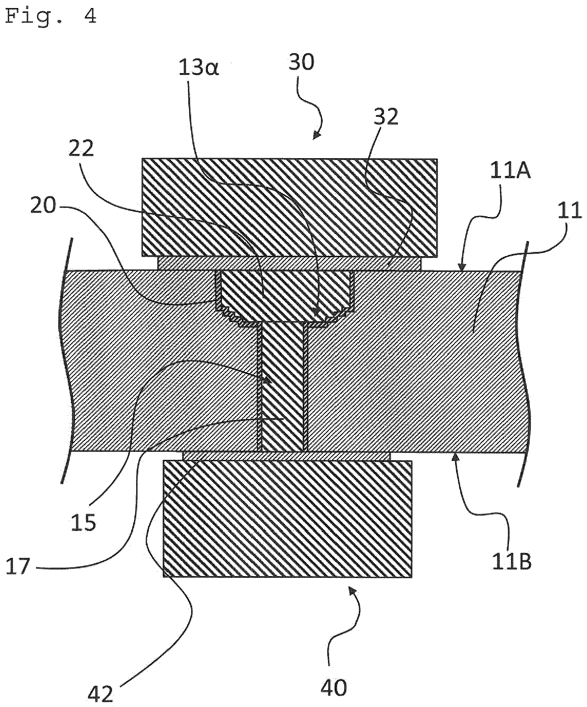

Fig. 4 is a cross-sectional view of another embodiment of the sapphire structure with a metal body of the present invention. In the embodiment illustrated in Fig. 4, the sapphire structure 11 is a plate-like body including the flat surface 11A as a first surface and includes a through-hole 15 including openings on the bottom surface 13α of the concave portion 12 and the second surface 11B. Further, the sapphire structure 11 includes a via conductor 17 which fills in the through-hole 15 and is made of a metal. In the embodiment illustrated in Fig. 4, a first device arranged on the flat surface 11A side and a second device arranged on the second surface 11B side can be conducted through the via conductor 17 and the metal body 20.

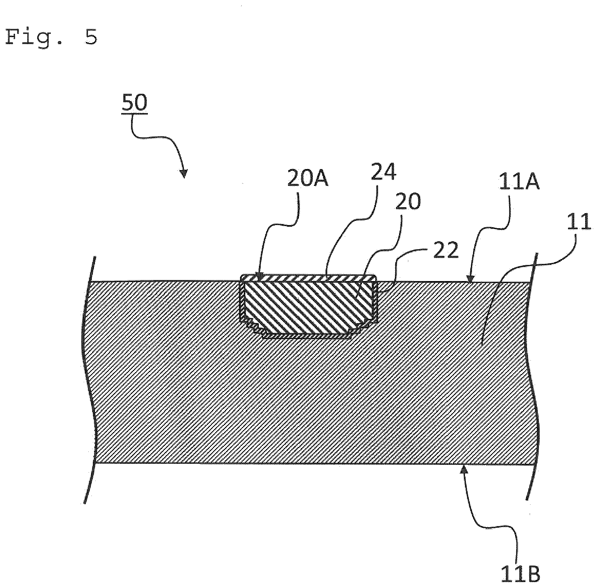

In addition, Fig. 5 is a cross-sectional view illustrating an embodiment of a member with a metal pattern using the sapphire structure with a metal body of the present invention. A member 50 with a metal pattern illustrated in Fig. 5 is a member in which, for example, a gold (Au)-plated metal layer 24 is arranged on the surface portion 20A of the metal body 20 of the structure 10 with a metal body. In this manner, the metal layer 24 made of a metal different from the metal body 20 is formed on the surface portion 20A of the metal body 20 and the external appearance or the electrical characteristics of the sapphire structure 10 with a metal body can be adjusted.

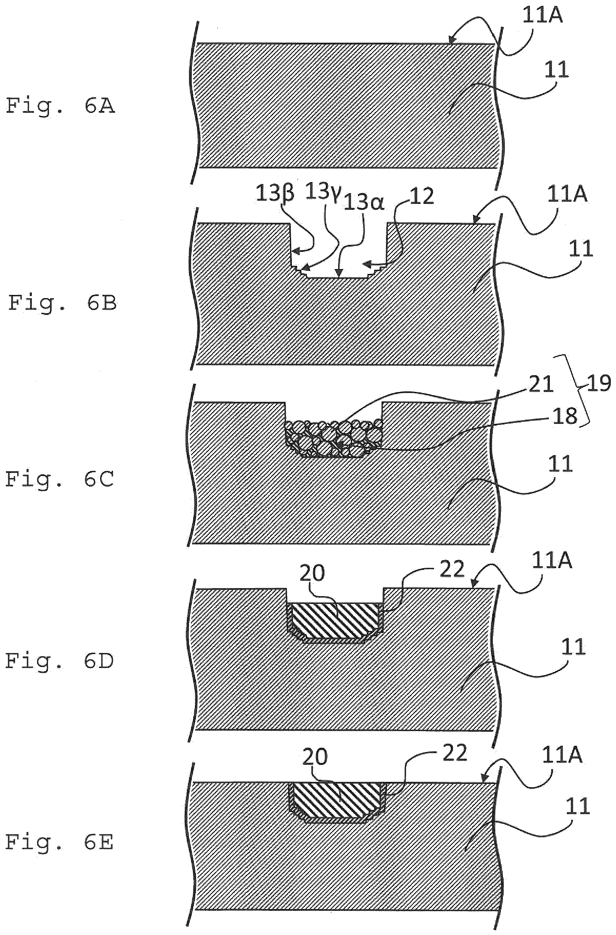

Figs. 6A to 6E are cross-sectional views illustrating an embodiment of a method of producing the sapphire structure with a metal body of the present invention. In the present embodiment, the method includes a process of forming the concave portion 12 (see Fig. 6B) on the flat surface 11A by performing processing on part of the flat surface 11A of the sapphire structure 11 (see Fig. 6A) including the flat surface 11A; a process of applying metal paste 19 (see Fig. 6C) which contains metal particles 21 and a solvent 18 to the formed in the concave portion 12; a process of forming the metal body 20 (see Fig. 6D) which is arranged in the concave portion 12 and bonded to the inner surface 13 of the concave portion 12 by heating the sapphire structure 11 to which the metal paste 19 is applied to evaporate the solvent 18 contained in the metal paste 19 and to bind the metal particles 21 to each other; and a process of polishing the flat surface 11A (see Fig. 6E) and the surface portion 20A of the metal body 20, and, in the polishing process, at least part of the surface portion 20A of the metal body 20 becomes substantially with the flat surface 11A by polishing the flat surface 11A and the surface portion 20A of the metal body 20 at the same time.

Hereinafter, respective processes will be described in detail. First, as illustrated in Fig. 6A, as the sapphire structure 11 having the flat surface 11A, a substantially circular sapphire substrate having a thickness of 600 µm is prepared.

Next, as illustrated in Fig. 6B, the concave portion 12 is formed on the flat surface 11A by performing processing on part of the flat surface 11A of the sapphire structure 11 by milling using a so-called machining center device. Specifically, grinding processing is performed on a portion corresponding to the concave portion 12 of the sapphire structure 11 by rotating and moving a so-called diamond electrodeposition tool to which diamond abrasive grains are adhered. The depth of the concave portion 12 is set to, for example, approximately 120 µm. Sapphire is a material which has high hardness and is difficult to make process, and the surface after milling is hard to be flat. Particularly, since the inclined surface 13γ in the inner surface 13 of the concave portion 12 is difficult to make hit by the diamond electrodeposition tool because of the stability compared to the bottom surface 13α and the side surface 13β, the inclined surface 13γ is easy to be inclined and the arithmetic surface roughness of the inclined surface 13γ becomes greater compared to the bottom surface 13α and the side surface 13β. In the present embodiment, the temperature of the entire sapphire structure 11 is increased to, for example, 1650°C after milling, and annealing processing which maintains the temperature range of 1500°C to 1800°C is performed for approximately 3 hours. By the annealing processing, the internal stress remaining on the inner surface 13 of the concave portion 12 after milling can be reduced.

Next, as illustrated in Fig. 6C, the metal paste 19 containing metal particles 21 and the solvent 18 is applied to the formed concave portion 12 using a brush member and the like for applying metal paste. In this embodiment the metal paste 19 is applied so as to a surface of the metal paste 19 is positioned nearer than the flat surface 11A relative to the bottom surface 13α of the concave portion 20. For example, the metal paste 19 is applied to the concave portion 12 such that the thickness thereof becomes in the range of 60 µm to less than 120 µm In the present embodiment, the metal particles 21 contain silver (Ag) as a main component and the metal paste 19 further contains silicon dioxide (SiO₂) together with a solvent. In addition, the metal paste 19 further contains copper (Cu) particles and still further contains titanium (Ti) particles. For example, as the metal paste 19, paste in which approximately 65% by mass of silver (Ag) particles, approximately 28% by mass of copper (Cu) particles, and titanium (Ti) particles are contained and silicon dioxide (SiO₂) particles and the solvent 18 are mixed may be used.

Next, as illustrated in Fig. 6D, the sapphire structure 11 to which the metal paste 19 is applied is heated, for example, at a temperature of 600°C to 900°C, the solvent 18 contained in the metal paste 19 is evaporated, and the metal particles 21 are bound to each other to be arranged in the concave portion 12, thereby forming the metal body 20 bonded to the inner surface 13 of the concave portion 12. In the present embodiment, since the metal paste 19 includes copper (Cu), a compound of silver (Ag) and copper (Cu) is formed by firing, and the hardness of the metal body 20 becomes higher compared to the case where the metal paste 19 only contains silver (Ag). Further, since the metal body 20 contains titanium (Ti), the bonding layer 22 containing titanium (Ti) as a main component is formed in a bonding area in which the inner surface 13 is bonded to the metal body 20 by firing, and the metal body 20 and the inner surface 13 are relatively strongly bonded to each other. Further, since the metal paste 19 contains silicon dioxide (SiO₂), the silicon dioxide (SiO₂) ingredients are diffused to the sapphire structure 11 side by firing, and the bonding strength between the metal body 20 and the sapphire structure 11 becomes relatively strong. After firing, the entire body is washed using an organic solvent, pure water, or the like as needed.

Subsequently, at least part of the surface 20A of the metal body 20 is made substantially with the flat surface 11A by polishing the flat surface 11A and the surface portion 20A of the metal body 20. The polishing process includes a first step in which the flat surface 11A is polished but the metal body 20 is not polished and a second step in which the flat surface 11A and the metal body 20 are polished at the same time. In the first step, mechanical polishing is performed using a copper plate as a polishing pad and diamond abrasive grains having a grain size of approximately 1 µm to 3 µm as abrasive grains for polishing. In the first step, only a portion of the flat surface 11A which further protrudes than the surface portion 20A of the metal body 20 is selectively polished so that the flat surface 11A after polishing becomes substantially with the surface portion 20A of the metal body 20. After the first step, chemical mechanical polishing (so-called CMP) is performed using colloidal silica abrasive grains having a grain size of approximately 20 µm to 80 µm as abrasive grains for polishing. In the chemical mechanical polishing, not only the flat surface 11A of the sapphire structure 11 but also the surface portion 20A of the metal body 20 is polished at the same time. The flat surface 11A of the sapphire structure 11 made of a single crystal (sapphire) of alumina is flattened with high precision by the chemical mechanical polishing. For example, the arithmetic average roughness of the flat surface 11A of the sapphire structure 11 can be adjusted to 10 nm or less by the chemical mechanical polishing and, further, the arithmetic average roughness of the flat surface 11A can be adjusted to 1 nm or less. The metal body 20 is a layer obtained by metal particles 21 in the metal paste 19 described above being bound to each other and polishing advances such that the metal particles 21 are partially peeled off in the polishing by the chemical mechanical polishing. Therefore, unevenness according to the shape of the metal particles 21 is present in the surface portion 20A of the metal body 20 after the chemical mechanical polishing and the arithmetic average roughness (Ra) of the surface portion 20A which is substantially with the flat surface 11A becomes greater compared to the arithmetic average roughness (Ra) of the flat surface 11A. The structure 10 with a metal body can be produced, for example, by performing the above-described processes. In addition, for example, a process of filling the metal paste 19 in the through-hole 15 may be provided instead of the process of applying the metal paste 19 to the concave portion 12 using the sapphire structure 11 on which the through-hole 15 is formed in advance in the case of producing the structure with the metal body of the embodiment illustrated in Fig. 4. The production method of the present invention is not particularly limited in regard to other conditions or the like.

### Electronic apparatus

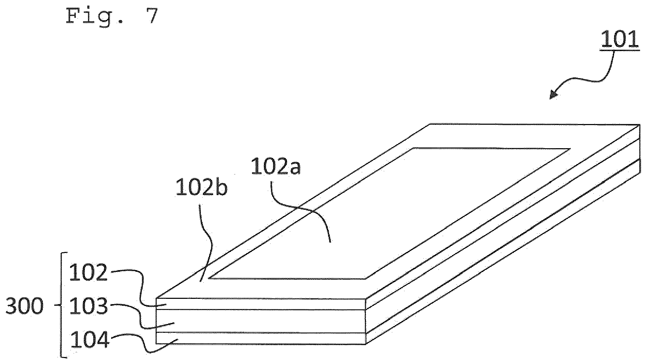

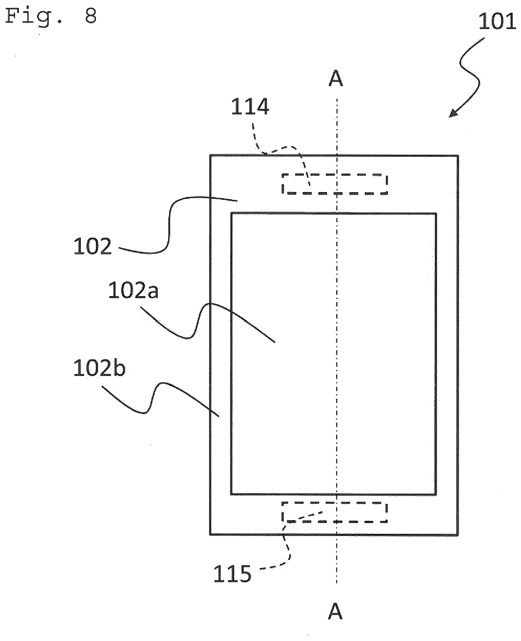

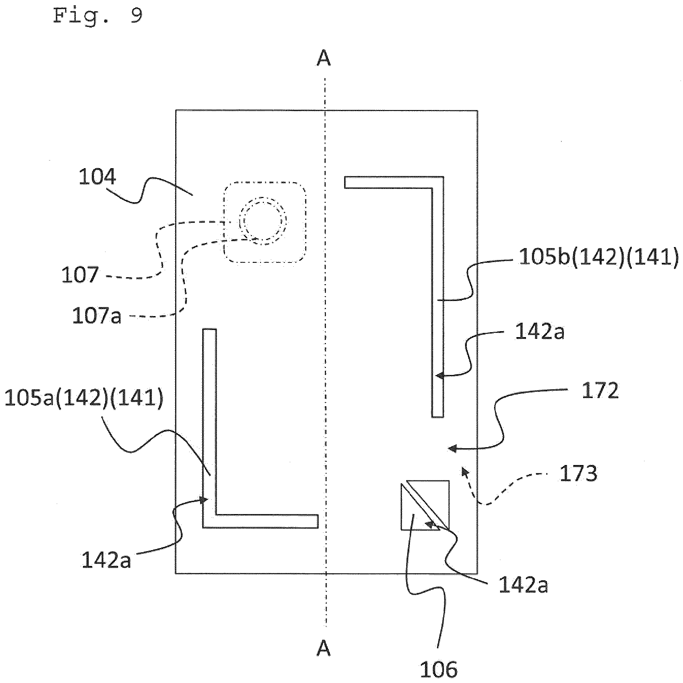

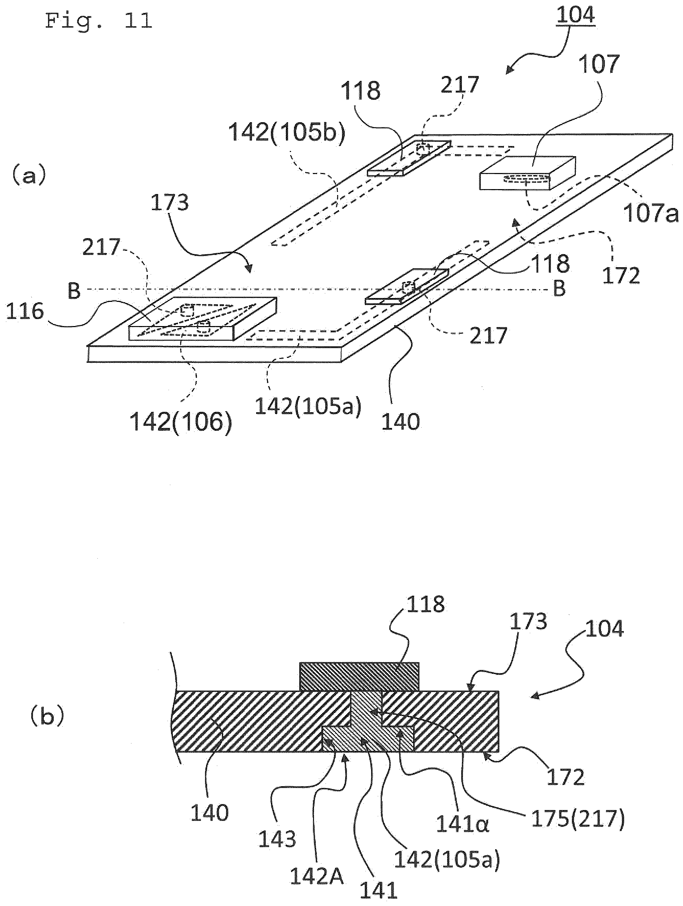

Figs. 7 to 11 are views illustrating the external appearance of the electronic apparatus configured using an embodiment of the sapphire structure with a metal body described above, and Figs. 7 to 10 are respectively a perspective view, a front view, a rear view, and an exploded perspective view. Fig. 11A is a perspective view when the rear surface side panel 104 is seen from the inside of the housing 103 and Fig. 11B is a cross-sectional view taken along a plane containing a B-B line. An electronic apparatus 101 according to the present embodiment is a mobile device such as a smart phone and can communicate with another communication device via a base station, a server, and the like. The shape of the electronic apparatus 101 is a substantially rectangular plate-like shape in a plan view. An exterior body 300 of the electronic apparatus 101 is configured of a front surface side panel 102, a housing 103, and a rear surface side panel 104.

The front surface side panel 102 is formed of a transparent hard material. The front surface side panel 102 contains sapphire as a main component. Sapphire has characteristics of being difficult to damage, being difficult to be broken, having high transparency, and having high thermal conductivity when compared to strengthened glass or the like.

The front surface side panel 102 includes a display area 102a and a peripheral edge area 102b. Various pieces of information such as characters, symbols, figures, and moving images displayed by a display device 112 described below are visually recognized by a user through the display area 102a in the front surface side panel 102.

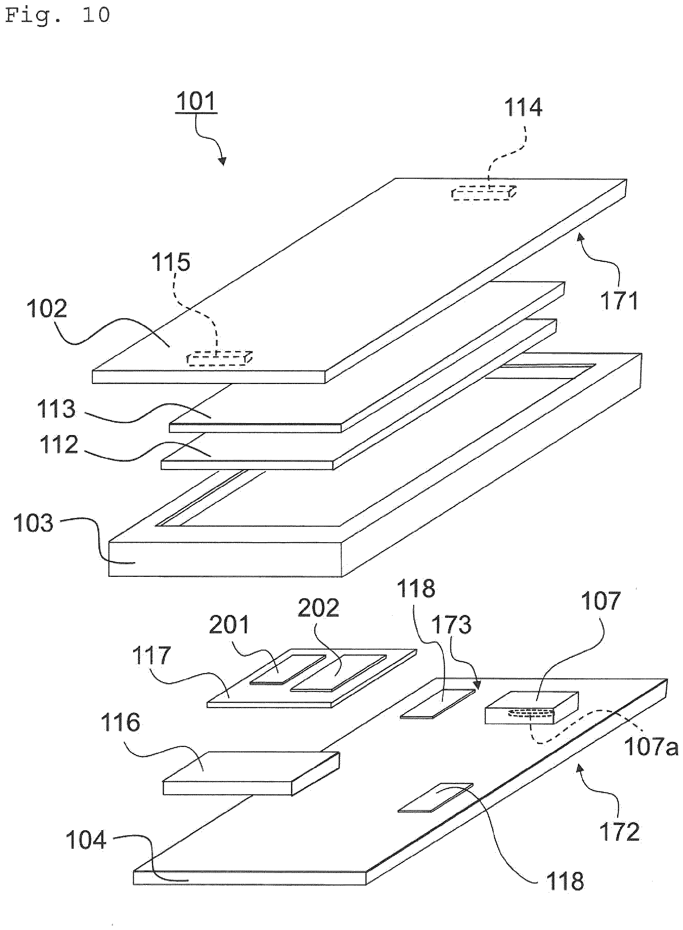

Further, as illustrated in Fig. 10, a touch panel 113 described below is attached to an inner surface 171 of the front surface side panel 102. The user can issue various instructions with respect to the electronic apparatus 101 by operating the display area 102a of the front surface side panel 102 using a finger or the like. A piezoelectric vibrating element 114 and a microphone 115 are attached to the inner surface 171 of the front surface side panel 102.

The housing 103 constitutes part of the side surface portion of the electronic apparatus 101. The housing 103 contains sapphire for instance as a main component similarly to the front surface side panel 102. In this embodiment, the housing 103 contains sapphire. But the material of the housing 103 is not limited in particular. For example, in the other embodiment, the housing 103 can contains metal as a main component, or only a part of the housing 103 can contains sapphire.

The rear surface side panel 104 is an embodiment of the sapphire structure with a metal body described above. The rear surface side panel 104 includes a flat surface (first surface 172), a sapphire structure 140in which a concave portion 141 is provided on the flat surface (first surface 172), and a metal body 142 arranged in the concave portion 141 and bonded to an inner surface 143 of the concave portion 141, and the metal body 142 includes a surface portion 142A which is substantially with the flat surface (first surface 172). The rear surface side panel 104 is plate-like and has a substantially rectangular shape in a plan view. The rear surface side panel 104 constitutes the rear surface portion of the electronic apparatus 101. The rear surface side panel 104 includes a first surface 172 constituting the rear surface of the electronic apparatus 101 and a second surface 173 positioned on the opposite side to the first surface 172.

Fig. 10 is an exploded perspective view of the electronic apparatus 101. In addition, in Fig. 10, part of components included in the electronic apparatus 101 such as a plurality of cables (or conductors) electrically connecting a plurality of electronic components to one another or the piezoelectric vibrating element 114 is omitted for avoiding complexity in the drawing. In the present embodiment, a bonding layer is formed between a bonded surface with the front surface side panel 102 and a bonded surface with the housing 103, and the bonded surface with the front surface side panel 102 is bonded to the bonded surface of the housing 103 through the bonding layer.

Moreover, a bonding layer is formed between a bonded surface with the housing 103 and a bonded surface with the rear surface side panel 104, and the bonded surface with the housing 103 is bonded to the bonded surface of the rear surface side panel 104 through the bonding layer.

Moreover, in the present embodiment, the case in which the exterior body 300 is configured of the front surface side panel 102, the housing 103, and the rear surface side panel 104 is described, the exterior body 300 may be configured by combining three members. The exterior body 300 may be configured of only one or two members or by combining four or more members.

The touch panel 113, the piezoelectric vibrating element 114, and the microphone 115 are attached to the inner surface 171 of the front surface side panel 102 using a double-sided tape or the like. The display device 112 is arranged so as to face the front surface side panel 102 and the touch panel 113 (more specifically, the front surface side panel 102 to which the touch panel 113 is attached).

A printed board 117 and a battery 116 on which various components such as a CPU (Central Processing Unit) 201 and a DSP (Digital Signal Processor) 201 are installed are arranged on the rear surface of the display device 112. In Fig. 10, the printed board 117 which is not illustrated in the drawing is electrically connected to a component included in the electronic apparatus 101 such as the touch panel 113 by a cable. In addition, the rear surface side panel 104 is arranged so as to face the printed board 117 and the battery 116. The battery 116 is connected with a terminal 106 as described below for charging by a metal body 142 embedded in the rear surface side panel 104 (Fig. 11a).

In this manner, the exterior body 300 configured of the front surface side panel 102, the housing 103, and the rear surface side panel 104 accommodates electronic devices such as the CPU 201 and the DSP 202. The devices in the exterior body 300 generate heat during operation in some cases. However, sapphire constituting the exterior body 300 has high heat dissipation compared to a resin generally used as a material of the exterior body of the electronic apparatus. For this reason, heat emitted from the device during the operation of the device can be efficiently dissipated to the outside of the electronic apparatus 101 through the exterior body 300. As a result, in the electronic apparatus 101 in the present embodiment, it is possible to suppress the temperature rise of the device in the exterior body 300 and suppress the temperature rise in the exterior body 300. Accordingly, operation failure of the electronic apparatus 101 can be suppressed.

The metal body 142 including a surface which is flush with the first surface 172 is arranged on the rear surface of the electronic apparatus 101, and the metal body 142 constitutes of antennas 105 (antennas 105a and 105b) and the terminal 106 for charging. In addition, a lens 107a included in an imaging unit 107 is oppositely arranged on the second surface 173 of the rear surface side panel 104. Since a sapphire member has a high light transmission property and the rear surface side panel 104 is a sapphire member, photographing can be performed by the imaging unit 107 in the exterior body 300.

As illustrated in Figs. 11A and 11B, the rear surface side panel 104 includes a through-hole 175 including openings on a bottom surface 141α of the concave portion 141 and the second surface 173. Further, the rear surface side panel 104 includes a via conductor 217 which fills in the through-hole 175 and is made of a metal. In the embodiment illustrated in Figs. 11A and 11B, the metal body 142 constituting the antenna 105a exposed to the surface of the electronic apparatus 101 is electrically connected to a communication circuit component or the like arranged on the second surface 173 side through the via conductor 217. Further, the metal body 142 constituting the terminal 106 exposed to the surface of the electronic apparatus 101 is electrically connected to a power terminal or the like (not illustrated) arranged on the second surface 173 side through the via conductor 172. In the electronic apparatus of the present embodiment, since the rear surface side panel 104 contains sapphire as a main component, the rear surface side panel 104 has high thermal conductivity and heat emitted by various devices or electronic circuits arranged in the exterior body 300 can be efficiently dissipated from the inside of the exterior body 300. Moreover, since sapphire has low electrical resistance, leakage (dark current) of a current from the antenna 105 or the terminal 106 arranged in the rear surface side panel 104 is small, malfunction of the electronic apparatus 101 caused by the dark current is suppressed. In addition, since the first surface 172 of the rear surface side panel 104 having a light transmission property is substantially with the surface of the metal body 142 having metallic glossiness, the electronic apparatus 101 has a characteristic appearance. The electronic apparatus 101 has high transmitting and receiving sensitivity of the wireless signal due to the antenna 105, has small malfunction caused by the dark current, is difficult to be broken because of high strength of the exterior body 300, and has excellent designability due to a characteristic appearance.

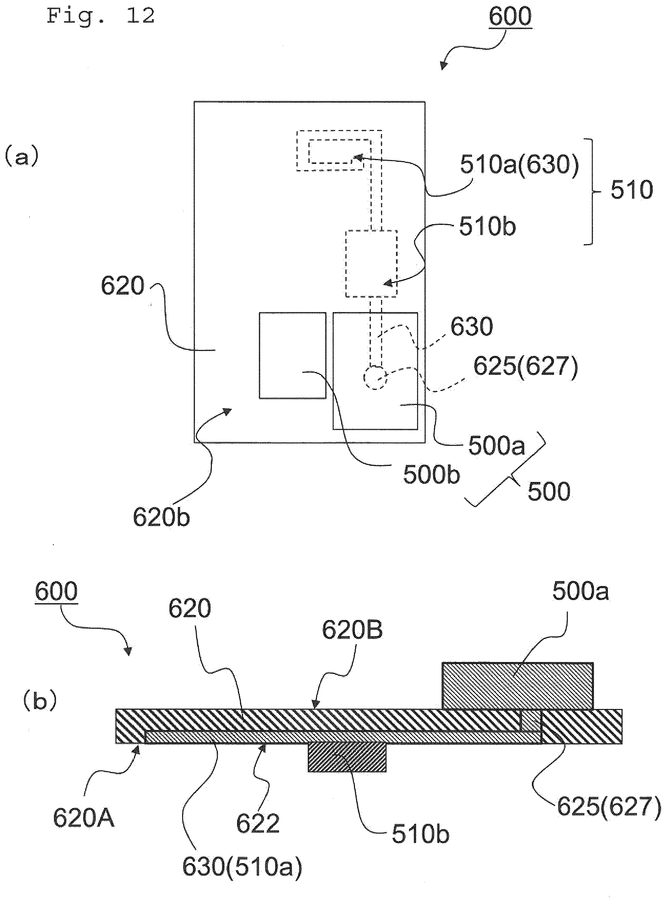

Figs. 12A and 12B illustrate an embodiment different from the embodiment described above in a case where the sapphire structure with a metal body described above is used for the electronic apparatus. Figs. 12A and 12B are schematic views describing a mounting body 600, and Fig. 12A is a plan view and Fig. 12B is a cross-sectional view. The mounting body 600 includes a first surface 620A, a mount board 620 in which a concave portion 622 is provided on the first surface 620A, and a metal body 630 arranged in the concave portion 622 and bonded to the inner surface of the concave portion 622, and the metal body 630 includes a surface which is substantially with the first surface 620A.

In the present embodiment, the metal body 630 contains silver (Ag) as a main component. In addition, the metal body 20 contains copper (Cu) and titanium (Ti). Further, the mount board 620 includes a through-hole 625 having openings on the bottom surface of the concave portion 622 and on a second surface 620B and a via conductor 627 which fills in the through-hole 625 and is made of a metal.

In the mounting body 600, a wireless communication unit 510 and the control unit 500 are arranged in the mount board 620. The control unit 500 includes the CPU 500a, the storage unit 500b, and the like and the control unit 500 is configured by the CPU 500a and the storage unit 500b being mounted on the second surface 620B. In addition, the wireless communication unit 510 is configured by an antenna 510a configured of the metal body 630 and a wireless information processing unit 510b mounted on the mount board 620 being arranged on the first surface 620A side. The wireless information processing unit 510b, the CPU 500a, and the storage unit 500b are devices including semiconductor elements. In the mounting body 600, the metal body 630 constitutes the antenna 510a, and the CPU 500a, the storage unit 500b, and the wireless information processing unit 510b are connected to one another using the metal body 630 or the via conductor 627 as electrical wiring.

The mount board 620 has high thermal conductivity because the mount board 620 is made of sapphire so that the heat emitted from the wireless communication unit 510 or the control unit 500 can be efficiently dissipated through the mount board 620. Since sapphire has low electrical resistance, a dark current flowing over the surface of the mount board 620 is suppressed so as to be small, and thus malfunction of the CPU 500a, the storage unit 500b, or the wireless information processing unit 510b, which is mounted on the surface of the mount board 620, caused by the dark current is suppressed.

The wireless information processing unit 510b, the CPU 500a, and the storage unit 500b, which are not limited to the device components including semiconductor elements, may be integrally formed on the mount board 620 by performing processing on a compound semiconductor layer which is formed on the mount board 620 made of sapphire. The mounting body 600 illustrated in Fig. 12A can be used by being arranged in the inside of the exterior body 300 of the electronic apparatus 101, for example.

### Electrical configuration of electronic apparatus

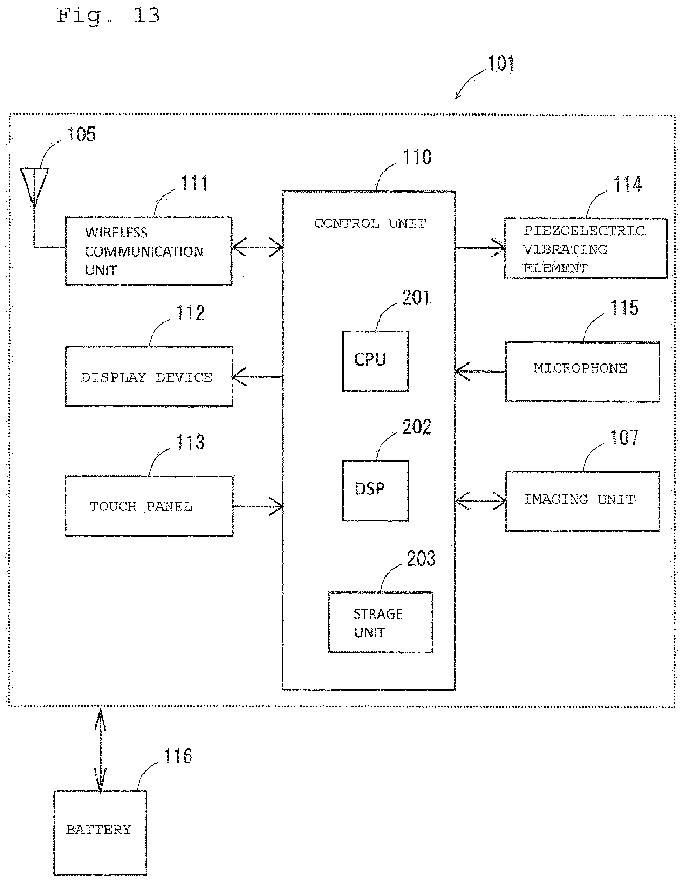

Fig. 13 is a block diagram illustrating the electrical configuration of the electronic apparatus 101. As illustrated in Fig. 13, the electronic apparatus 101 is provided with a control unit 110, a wireless communication unit 111, a display device 112, a touch panel 113, a piezoelectric vibrating element 114, a microphone 115, an imaging unit 107, and a battery 116. These constituent elements provided in the electronic apparatus 101 are accommodated in the exterior body 300 of the electronic apparatus 101.

The control unit 110 includes a CPU 201, a DSP 202, a storage unit 203, and the like. The control unit 110 manages the overall operation of the electronic apparatus 101 by controlling other constituent elements of the electronic apparatus 101. The storage unit 203 is configured of a Read Only Memory (ROM), a Random Access Memory (RAM), and the like. Main programs, a plurality of application programs, and the like which are control programs for controlling the electronic apparatus 101, specifically, for controlling respective constituent elements such as the wireless communication unit 11, and the display device 12 included in the electronic apparatus 101 are stored in the storage unit 203. Various functions of the control unit 110 can be realized by the CPU 201 and the DSP 202 executing various programs in the storage unit 203.

The wireless communication unit 111 includes antennas 105 (antennas 105a and 105b). The wireless communication unit 111 receives or transmits a communication signal from/to a mobile phone other than the electronic apparatus 101 or a communication device such as a web server connected to the Internet using an antenna 105 via a base station or the like.

The antenna 105 may be included in the rear surface side panel 104 as the present embodiment, or the antenna 105 arranged in the mounting body 600 may be positioned to the exterior body 300. The display device 112 is, for example, a liquid crystal display or an organic EL display. As described above, various pieces of information displayed by the display device 112 is visually recognized from the outside of the electronic apparatus 101 through the display area 102a.

The touch panel 113 is, for example, a projection type electrostatic capacitance touch panel. The touch panel 113 is attached to the inner surface 171 of the front surface side panel 102. The touch panel 113 includes two sheet-like electrode sensors which are arranged so as to face each other. When the user touches the display area 102a using an operator such as a finger or the like, the electrostatic capacitance of the portion facing the operator in the touch panel 113 is changed. Further, the touch panel 113 outputs an electrical signal according to the change of the electrostatic capacitance to the control unit 110. In this manner, the touch panel 113 can detect contact with respect to the display area 102a of the operator.

The piezoelectric vibrating element 114 and the microphone 115 are attached to the inner surface 171 of the front surface side panel 102. The piezoelectric vibrating element 114 is vibrated by a driving voltage applied from the control unit 110. The control unit 110 generates a driving voltage based on a sound signal and applies the driving voltage to the piezoelectric vibrating element 114. The front surface side panel 102 is vibrated based on the sound signal by the piezoelectric vibrating element 114 being vibrated based on the sound signal by the control unit 110. As a result, a reception sound is transmitted to the user from the front surface side panel 102. The volume of the reception sound is set to a degree such that the user can appropriately hear the sound when the front surface side panel 102 is set close against an ear of the user. Details of the piezoelectric vibrating element 114 and the reception sound transmitted to the user from the front surface side panel 102 will be described below in detail.

Further, in the description below, a case in which the reception sound is transmitted to the user from the front surface side panel 102 by the piezoelectric vibrating element 114 will be described, but a dynamic speaker that converts the electric sound signal from the control unit 110 into a sound and then outputs the sound may be adopted instead of the piezoelectric vibrating element 114. In the case of adopting the dynamic speaker, receiver holes are provided in the exterior body 300 (the front surface side panel 102, the housing 103, or the rear surface side panel 104). The sound output from the dynamic speaker is output to the outside from the receiver holes provided on the exterior body 300. Since sapphire is hard as described above, a process of providing a through-hole such as a receiver hole in the exterior body 300 made of sapphire is difficult to perform. Therefore, the number of processes on the exterior body 300 for providing the receiver hole is reduced by adopting the piezoelectric vibrating element 114 in which the receiver hole is not necessary to the electronic apparatus 101. As a result, the electronic apparatus 101 can be easily produced. Further, the exterior body 300 becomes weak by receiver hole being provided. However, in a case where the piezoelectric vibrating element 114 is adopted, since the receiver hole is not necessarily provided in the exterior body 300, the strength of the exterior body 300 can be maintained.

The microphone 115 converts vibration of the front surface side panel 102 into the electrical signal and outputs the converted signal to the control unit 110. The vibration of the front surface side panel 102 generates by the voice or the like of the user during communication on the phone or the like.

Further, the microphone 115 may not convert the vibration of the front surface side panel 102 into the electrical signal, but may convert air vibration such as the voice or the like of the user directly into an electrical signal and output the converted signal in the control unit 110. In this case, a microphone hole is provided in the exterior body 300 (the front surface side panel 102, the housing 103, or the rear surface side panel 104). The voice or the like of the user is incorporated in the inside of the electronic apparatus 101 from the microphone hole and input to the microphone 115.

The imaging unit 107 images a still image and a moving image. The battery 116 outputs power of the electronic apparatus 101. The power output from the battery 116 is supplied to each of the electronic components included in the control unit 110, the wireless communication unit 111, and the like included in the electronic apparatus 101.

### <Details of piezoelectric vibrating element>

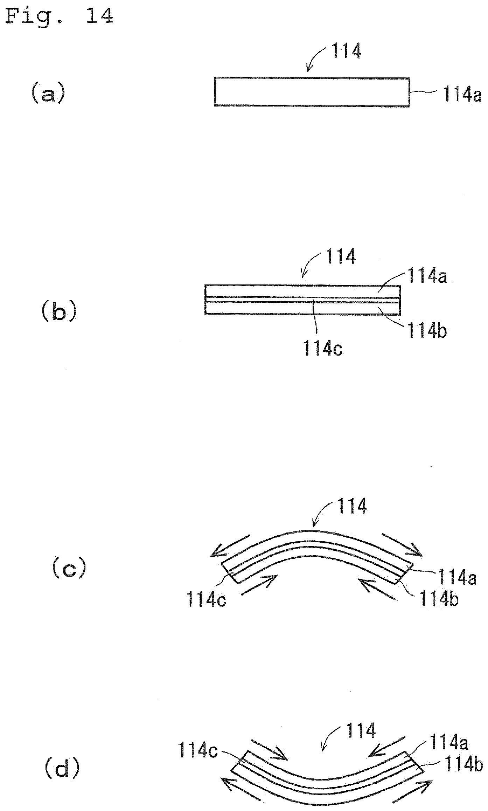

Figs. 14a is a top view illustrating a structure of the piezoelectric vibrating element 114. Figs. 14b is a side view. As illustrated in Figs. 14a and 14b, the piezoelectric vibrating element 114 has a long shape in one direction. Specifically, the piezoelectric vibrating element 114 has a long and narrow rectangular plate shape in a plan view. The piezoelectric vibrating element 114 has, for example, a bimorph structure and includes a first piezoelectric ceramic plate 114a and a second piezoelectric ceramic plate 114b which are attached to each other through a sim material 114c.

In the piezoelectric vibrating element 114, when a positive voltage is applied to the first piezoelectric ceramic plate 114a and a negative voltage is applied to the second piezoelectric ceramic plate 114b, the first piezoelectric ceramic plate 114a extends along the longitudinal direction and the second piezoelectric ceramic plate 114b contracts along the longitudinal direction. Accordingly, as illustrated in Fig. 14c, the piezoelectric vibrating element 114 is bent into a convex shape with the first piezoelectric ceramic plate 114a being outside.

In contrast, in the piezoelectric vibrating element 114, when a negative voltage is applied to the first piezoelectric ceramic plate 114a and a positive voltage is applied to the second piezoelectric ceramic plate 114b, the first piezoelectric ceramic plate 114a contracts along the longitudinal direction and the second piezoelectric ceramic plate 114b extends along the longitudinal direction. Accordingly, as illustrated in Fig. 14b, the piezoelectric vibrating element 114 is bent into a convex shape with the second piezoelectric ceramic plate 114b being outside.

The piezoelectric vibrating element 114 is bent and vibrates by alternatively taking the state of Fig. 14c and the state of Fig. 14d. The control unit 110 allows the piezoelectric vibrating element 114 to be bent and vibrate by applying an AC voltage in which the positive voltage and the negative voltage alternatively appear at an area between the first piezoelectric ceramic plate 114a and the second piezoelectric ceramic plate 114b.

In addition, only one structure made of the first piezoelectric ceramic plate 114a and the second piezoelectric ceramic plate 114b which are bonded to each other by interposing the sim material 114c therebetween is provided in the piezoelectric vibrating element 114 illustrated in Figs. 14, but a plurality of the structures may be laminated to each other.

The piezoelectric vibrating element 114 having the structures above is arranged to a peripheral area of the inner surface 171. More specifically, the piezoelectric vibrating element 114 is located on center of a short-length direction (right and left direction) of upper peripheral area of the inner surface 171 of the front surface side panel 102. In addition, the piezoelectric vibrating element 114 is located as their lengths in a direction along the short-length direction of the front surface side panel 102. Accordingly, the piezoelectric vibrating element 114 bent ant vibrates along the longitudinal direction and the second piezoelectric ceramic plate 114b extends along the short-length direction of the front surface side panel 102. And a center of long-length direction of the piezoelectric vibrating element 114 is positioned at the center of a short-length direction (right and left direction) of the inner surface 171.

The displacement amount of the piezoelectric vibrating element 114 is largest in the center of of long-length direction of the piezoelectric vibrating element 114 which bent and vibrates. Therefore, the area of the piezoelectric vibrating element 114 which displacement amount is the largest is positioned at the center of a short-length direction (right and left direction) of the inner surface 171 as a result of that a center of long-length direction of the piezoelectric vibrating element 114 is positioned at the center of a short-length direction (right and left direction) of the inner surface 171.

### <Regarding generation of reception sound>

At the electronic apparatus 101 of the present embodiment, an air conduction sound and a conduction sound are transmitted to the user from the front surface side panel 102 by the piezoelectric vibrating element 114 allowing the front surface side panel 102 to vibrate. That is, the vibration of the piezoelectric vibrating element 114 is transmitted to the front surface side panel 102 so that the air conduction sound and the conduction sound are transmitted to the user from the front surface side panel 102.

Here, the term "air conduction sound" means a sound recognized in a human brain by the vibration of an eardrum due to a sound wave (air vibration) which enters an external auditory meatus hole (a so-called "ear hole"). On the other hand, the term "conduction sound" is a sound recognized in a human brain by the vibration of the eardrum due to the vibration of an auricle transmitted to the eardrum after the auricle is vibrated. Hereinafter, the air conduction sound and the conduction sound will be described in detail.

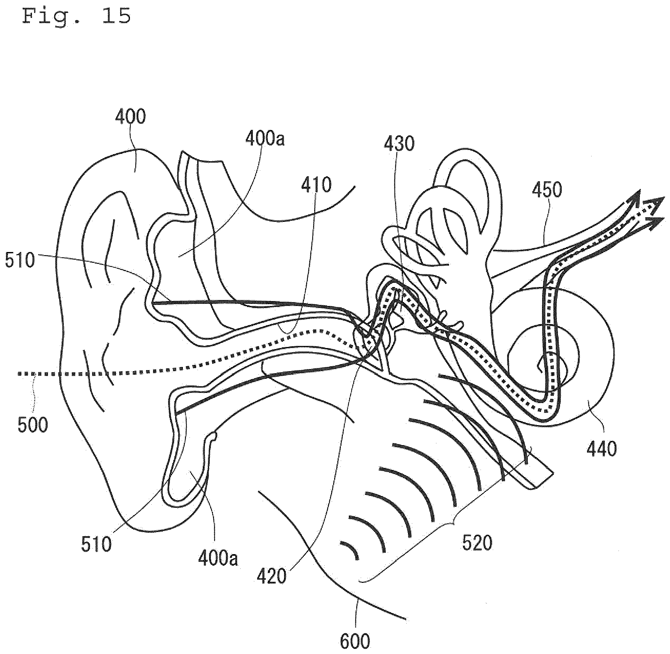

Fig. 15 is a view for describing the air conduction sound and the conduction sound. Fig. 15 illustrates a structure of an ear of the user of the electronic apparatus 101. In Fig. 15, a wavy line 500 indicates a conduction path of a sound signal (sound information) while the air conduction sound is recognized in the brain and a solid line 510 indicates the conduction path of the sound signal while the conduction sound is recognized in the brain.

When the piezoelectric vibrating element 114 mounted to the front surface side panel 102 vibrates based on the electric sound signal indicating the reception sound, the front surface side panel 102 vibrates and a sound wave is output from the front surface side panel 102. When the user moves the front surface side panel 102 of the electronic apparatus 101 close to an auricle 400 of the user by holding the electronic apparatus 101 in a hand or the front surface side panel 102 of the electronic apparatus 101 is set against the auricle 400 of the user, the sound wave output from the front surface side panel 102 enters an external auditory meatus hole 410. The sound wave from the front surface side panel 102 advances in the external auditory meatus hole 410 and allows the eardrum 420 to vibrate. The vibration of the eardrum 420 is transmitted to au auditory ossicle 430 and the auditory ossicle 430 vibrates. In addition, the vibration of the auditory ossicle 430 is transmitted to a cochlea 440 and is converted into an electrical signal in the cochlea 440. The electrical signal is transmitted to the brain by passing through an acoustic nerve 450 and the reception sound is recognized in the brain. In this manner, the air conduction sound is transmitted from the front surface side panel 102 to the user.

Further, when the user sets the front surface side panel 102 of the electronic apparatus 101 against the auricle 400 of the user by holding the electronic apparatus 101 in a hand, the auricle 400 is vibrated by the front surface side panel 102 which is vibrated by the piezoelectric vibrating element 114. The vibration of the auricle 400 is transmitted to the eardrum 420, and thus the eardrum 420 vibrates. The vibration of the eardrum 420 is transmitted to the auditory ossicle 430, and thus the auditory ossicle 430 vibrates. In addition, the vibration of the auditory ossicle 430 is transmitted to the cochlea 440 and is converted into an electrical signal in the cochlea 440. The electrical signal is transmitted to the brain by passing through the acoustic nerve 450 and the reception sound is recognized in the brain. In this manner, the conduction sound is transmitted from the front surface side panel 102 to the user. Fig. 15 illustrates an auricular cartilage 400a in the inside of the auricle 400.

In addition, the conduction sound herein is different from a bone conduction sound (also referred to as a "bone conduction sound"). The bone conduction sound is a sound recognized in a human brain by the vibration of the skull and direct stimulation of the inner ear such as the cochlea caused by the vibration of the skull. In Fig. 15, in a case of vibrating the jawbone 600, the transmission path of the sound signal while the bone conduction sound is recognized in the brain is indicated with a plurality of arcs 520.

In this manner, in the electronic apparatus 101 according to the present embodiment of the present invention, the air conduction sound and the conduction sound can be transmitted from the front surface side panel 102 to the user of the electronic apparatus 101 by allowing the front surface side panel 102 of the front surface to appropriately vibrates through the piezoelectric vibrating element 114. The structure of the piezoelectric vibrating element 114 according to the present embodiment is designed such that the air conduction sound and the conduction sound can be appropriately transmitted to the user. Various advantages are generated by constituting the electronic apparatus 101 such that the air conduction sound and the conduction sound can be transmitted to the user.

For example, since the user can hear a sound when the user sets the front surface side panel 102 against an ear, the communication using a telephone can be performed without concerning the position of the electronic apparatus 101 set against an ear so much.

In addition, in a case where there is a large amount of ambient noise, it is possible to increase the volume of the conduction sound and to make difficult for the ambient noise to be heard by the user by strongly pressing the ear against the front surface side panel 102. Accordingly, the user can appropriately perform communication using a telephone even when there is a large amount of the ambient noise.

In addition, even in a state in which earplugs or earphones are fixed to the ears of the user, the reception sound from the electronic apparatus 101 can be recognized by putting the front surface side panel 102 against the ear (more specifically the auricle). Further, even in the state in which headphones are fixed to the ears of the user, the reception sound from the electronic apparatus 101 can be recognized by setting the front surface side panel 102 against the headphones.

Further, in the above-described example, a mobile electronic apparatus such like smartphone to which the present invention is applied is described as an example, but the present invention can be applied to an mobile electronic apparatus other than the smart phone. For example, the present invention can be applied to a tablet device, watch, and the like.

Thus, the electronic apparatus 101 is described specifically. But the above-described example is merely one example in every aspect. And various modifications which are not described above may be made according to the appended claims.

### References

- 10: : the structure with a metal body
- 11: : sapphire structure
- 11A: : flat surface
- 11B: : second surface
- 12: : concave portion
- 13: : inner surface
- 13α: : bottom surface
- 13β: : side surface
- 13γ: : inclined surface
- 17: : via conductor
- 18: : solvent
- 19: : metal paste
- 20: : metal body
- 20A: : surface portion
- 21: : metal particles
- 30: : first device
- 40: : second device

## Claims

1. A sapphire structure (10) with a metal body, comprising:
a sapphire structure (11) that includes a flat surface (11A) and is provided with a concave portion (12) on the flat surface (11A); and
a metal body (20) that is disposed in the concave portion (12) and bonded to an inner surface (13) of the concave portion (12),
wherein the metal body (20) includes a surface portion (20A) that is substantially flush with the flat surface (11A),
the sapphire structure being **characterized in that**:
the inner surface (13) of the concave portion (12) includes a bottom surface (13α), a side surface (13β), and an inclined surface (13γ) being located between the bottom surface (13α) and the side surface (13β),
wherein the inclined surface (13γ) inclines to the bottom surface (13α) and the side surface (13β),
wherein the inclined surface (13γ) has an arithmetic average surface roughness greater than that of the bottom surface (13α) and the side surface (13β).

2. The sapphire structure (10) with a metal body according to claim 1, wherein the metal body (20) contains silver as a main component.

3. The sapphire structure (10) with a metal body according to claim 2, wherein the metal body (20) contains silicon dioxide (SiO₂).

4. The sapphire structure (10) with a metal body according to claim 2 or 3, wherein the metal body (20) contains copper (Cu).

5. The sapphire structure (10) with a metal body according to any one of claims 2 to 4, wherein the metal body (20) contains titanium (Ti).

6. The sapphire structure (10) with a metal body according to claim 5, wherein the metal body (20) having a bonding layer (22) containing titanium (Ti) as a main component being formed in a bonding area bonded to the inner surface (13).

7. The sapphire structure (10) with a metal body according to any one of claims 1 to 6, wherein the sapphire structure (11) is a plate-like body using the flat surface (11A) as a first surface and includes a through-hole (15) with openings on a bottom surface (13α) of the concave portion (12) and a second surface (11B) positioned on the opposite side to the first surface.

8. The sapphire structure (10) with a metal body according to claim 7, further comprising a via conductor (17) made of a metal and filling the through-hole (15).

9. The sapphire structure (10) with a metal body according to any one of claims 1 to 8, wherein an arithmetic average roughness (Ra) of the surface portion (20A) of the metal body (20) that is substantially flush with the flat surface (11A) is greater than the arithmetic average roughness (Ra) of the flat surface (11A).

10. The sapphire structure (10) with a metal body according to any one of claims 1 to 9, wherein the arithmetic average roughness of the flat surface (11A) is 10 nm or lower.

11. The sapphire structure (10) with a metal body according to claim 6, wherein the arithmetic average roughness of the flat surface (11A) is 1 nm or lower.

12. A method of producing a sapphire structure with a metal body, comprising:
forming a concave portion (12) on a flat surface (11A) by performing processing on part of the flat surface (11A) of a sapphire structure (11) including the flat surface (11A)
applying metal paste (19) that contains metal particles (21) and a solvent (18) to the inside of the formed concave portion (12);
forming a metal body (20) that is disposed in the concave portion (12) and bonded to an inner surface (13) of the concave portion (12) by heating the sapphire structure (11) to which the metal paste (19) is applied to evaporate the solvent (18) contained in the metal paste (19) and to bind the metal particles (21) to each other; and
polishing the flat surface (11A) and a surface of the metal body (20),
wherein, in the polishing, at least part of the surface of the metal body (20) becomes substantially flush with the flat surface (11A) by polishing the flat surface (11A) and the surface of the metal body (20) at the same time;
the method being **characterized in that** the inner surface (13) of the formed concave portion (12) includes a bottom surface (13a), a side surface (13β), and an inclined surface (13y) being located between the bottom surface (13a) and the side surface (13β), wherein the inclined surface (13y) inclines to the bottom surface (13a) and the side surface (13β), wherein the inclined surface (13y) has an arithmetic average surface roughness greater than that of the bottom surface (13α) and the side surface (13β).

13. The method of producing a sapphire structure with a metal body according to claim 12,
wherein the metal particles (21) contain silver as a main component, and
the metal paste (19) contains silicon dioxide.

14. The method of producing a sapphire structure with a metal body according to claim 12 or 13, wherein the metal paste (19) further contains copper particles.

15. The method of producing a sapphire structure with a metal body according to any one of claims 12 to 14, wherein the metal paste (19) further contains titanium particles.

16. The method of producing a sapphire structure with a metal body according to any one of claims 12 to 15,
wherein, in the applying, the surface of the metal body (20) disposed in the concave portion (12) is positioned closer to a bottom surface (13α) of the concave portion (12) than the flat surface (11A), and
the polishing includes a first step in which the metal body (20) is not polished while the flat surface (11A) is polished and a second step in which the flat surface (11A) and the metal body (20) are polished at the same time.

17. An electronic apparatus (101), comprising:
a device (201, 202); and
an exterior body (300) that houses the device (201, 202),
wherein a sapphire structure with a metal body according to any one of claims 1 to 11 is used for at least part of the exterior body (300).

18. An electronic apparatus (101), comprising:
a device (510b, 500a, 500b); and
a mounting body (600) on which the device (510b, 500a, 500b) is disposed,
wherein a sapphire structure with a metal body according to any one of claims 1 to 11 is used for at least part of the mounting body (600).

19. An exterior body (300), wherein the exterior body (300) is used for an electronic apparatus (101) and is configured using a sapphire structure with a metal body according to any one of claims 1 to 11.

## Patentansprüche

1. Saphirstruktur (10) mit einem Metallkörper, aufweisend:
eine Saphirstruktur (11), die eine flache Fläche (11A) aufweist und mit einem konkaven Abschnitt (12) auf der flachen Fläche (11A) versehen ist, und
einen Metallkörper (20), der in dem konkaven Abschnitt (12) angeordnet und mit einer Innenfläche (13) des konkaven Abschnitts (12) verbunden ist,
wobei der Metallkörper (20) einen Flächenabschnitt (20A) aufweist, der im Wesentlichen bündig mit der flachen Fläche (11A) ist,
wobei die Saphirstruktur **dadurch gekennzeichnet ist, dass**:
die Innenfläche (13) des konkaven Abschnitts (12) eine untere Fläche (13α), eine Seitenfläche (13β) und eine Neigungsfläche (13γ) aufweist, die sich zwischen der unteren Fläche (13α) und der Seitenfläche (13β) befindet,
wobei die Neigungsfläche (13γ) zu der unteren Fläche (13α) und der Seitenfläche (13β) geneigt ist,
wobei die Neigungsfläche (13γ) einen arithmetischen Mittelrauwert hat, der größer als derjenige der unteren Fläche (13α) und der Seitenfläche (13β) ist.

2. Saphirstruktur (10) mit einem Metallkörper gemäß Anspruch 1, wobei der Metallkörper (20) Silber als eine Hauptkomponente enthält.

3. Saphirstruktur (10) mit einem Metallkörper gemäß Anspruch 2, wobei der Metallkörper (20) Siliziumdioxid (SiO₂) enthält.

4. Saphirstruktur (10) mit einem Metallkörper gemäß Anspruch 2 oder 3, wobei der Metallkörper (20) Kupfer (Cu) enthält.

5. Saphirstruktur (10) mit einem Metallkörper gemäß irgendeinem der Ansprüche 2 bis 4, wobei der Metallkörper (20) Titan (Ti) enthält.

6. Saphirstruktur (10) mit einem Metallkörper gemäß Anspruch 5, wobei der Metallkörper (20) eine Verbindungsschicht (22) aufweist, die Titan (Ti) als eine Hauptkomponente enthält und in einem Verbindungsbereich ausgebildet ist, der mit der Innenfläche (13) verbunden ist.

7. Saphirstruktur (10) mit einem Metallkörper gemäß irgendeinem der Ansprüche 1 bis 6, wobei die Saphirstruktur (11) ein plattenartiger Körper ist, der die flache Fläche (11A) als eine erste Fläche verwendet, und ein Durchgangsloch (15) mit Öffnungen auf einer unteren Fläche (13α) des konkaven Abschnitts (12) und einer zweiten Fläche (11B) aufweist, die auf der zu der ersten Fläche entgegengesetzten Seite angeordnet ist.

8. Saphirstruktur (10) mit einem Metallkörper gemäß Anspruch 7, ferner aufweisend einen Durchgangsleiter (17), der aus einem Metall gebildet ist und das Durchgangsloch (15) füllt.

9. Saphirstruktur (10) mit einem Metallkörper gemäß irgendeinem der Ansprüche 1 bis 8, wobei ein arithmetischer Mittelrauwert (Ra) des Flächenabschnitts (20A) des Metallkörpers (20), der im Wesentlichen bündig mit der flachen Fläche (11A) ist, größer als der arithmetische Mittelrauwert (Ra) der flachen Fläche (11A) ist.

10. Saphirstruktur (10) mit einem Metallkörper gemäß irgendeinem der Ansprüche 1 bis 9, wobei der arithmetische Mittelrauwert der flachen Fläche (11A) 10 nm oder weniger beträgt.

11. Saphirstruktur (10) mit einem Metallkörper gemäß Anspruch 6, wobei der arithmetische Mittelrauwert der flachen Fläche (11A) 1 nm oder weniger beträgt.

12. Verfahren zum Herstellen einer Saphirstruktur mit einem Metallkörper, aufweisend:
Bilden eines konkaven Abschnitts (12) auf einer flachen Fläche (11A) durch Durchführen einer Bearbeitung auf einem Teil der flachen Fläche (11A) einer Saphirstruktur (11) einschließlich der flachen Fläche (11A),
Aufbringen einer Metallpaste (19), die Metallpartikel (21) und ein Lösungsmittel (18) enthält, auf das Innere des ausgebildeten konkaven Abschnitts (12),
Bilden eines Metallkörpers (20), der in dem konkaven Abschnitt (12) angeordnet und mit einer Innenfläche (13) des konkaven Abschnitts (12) verbunden ist, durch Erwärmen der Saphirstruktur (11), auf die die Metallpaste (19) aufgebracht ist, um das in der Metallpaste (19) enthaltene Lösungsmittel (18) zu verdampfen und die Metallteilchen (21) aneinander zu binden, und
Polieren der flachen Fläche (11A) und einer Fläche des Metallkörpers (20),
wobei beim Polieren mindestens ein Teil der Fläche des Metallkörpers (20) im Wesentlichen bündig mit der flachen Fläche (11A) wird, durch Polieren der flachen Fläche (11A) und der Fläche des Metallkörpers (20) zur gleichen Zeit,
wobei das Verfahren **dadurch gekennzeichnet ist, dass** die Innenfläche (13) des ausgebildeten konkaven Abschnitts (12) eine untere Fläche (13a), eine Seitenfläche (13β) und eine Neigungsfläche (13γ) aufweist, die zwischen der unteren Fläche (13a) und der Seitenfläche (13β) angeordnet ist, wobei die Neigungsfläche (13γ) zu der unteren Fläche (13α) und der Seitenfläche (13β) geneigt ist, wobei die Neigungsfläche (13γ) einen arithmetischen Mittelrauwert hat, der größer als derjenige der unteren Fläche (13α) und der Seitenfläche (13β) ist.

13. Verfahren zum Herstellen einer Saphirstruktur mit einem Metallkörper gemäß Anspruch 12,
wobei die Metallpartikel (21) Silber als eine Hauptkomponente enthalten und
die Metallpaste (19) Siliciumdioxid enthält.

14. Verfahren zum Herstellen einer Saphirstruktur mit einem Metallkörper gemäß Anspruch 12 oder 13, wobei die Metallpaste (19) ferner Kupferpartikel enthält.

15. Verfahren zum Herstellen einer Saphirstruktur mit einem Metallkörper gemäß irgendeinem der Ansprüche 12 bis 14, wobei die Metallpaste (19) ferner Titanpartikel enthält.

16. Verfahren zum Herstellen einer Saphirstruktur mit einem Metallkörper gemäß irgendeinem der Ansprüche 12 bis 15,
wobei beim Aufbringen die Fläche des in dem konkaven Abschnitt (12) angeordneten Metallkörpers (20) näher bei einer unteren Fläche (13α) des konkaven Abschnitts (12) als die flache Fläche (11A) positioniert wird, und
das Polieren einen ersten Schritt, bei dem der Metallkörper (20) nicht poliert wird, während die flache Fläche (11A) poliert wird, und einen zweiten Schritt aufweist, bei dem die flache Fläche (11A) und der Metallkörper (20) gleichzeitig poliert werden.

17. Elektronische Vorrichtung (101), aufweisend:
eine Vorrichtung (201, 202) und
einen äußeren Körper (300), der die Vorrichtung (201, 202) aufnimmt,
wobei für mindestens einen Teil des äußeren Körpers (300) eine Saphirstruktur mit einem Metallkörper gemäß irgendeinem der Ansprüche 1 bis 11 verwendet wird.

18. Elektronische Vorrichtung (101), aufweisend:
eine Vorrichtung (510b, 500a, 500b) und
einen Montagekörper (600), auf dem die Vorrichtung (510b, 500a, 500b) angeordnet ist,
wobei für mindestens einen Teil des Montagekörpers (600) eine Saphirstruktur mit einem Metallkörper gemäß irgendeinem der Ansprüche 1 bis 11 verwendet wird.

19. Äußerer Körper (300), wobei der äußere Körper (300) für eine elektronische Vorrichtung (101) verwendet wird und mittels einer Saphirstruktur mit einem Metallkörper gemäß irgendeinem der Ansprüche 1 bis 11 konfiguriert ist.

## Revendications

1. Structure de saphir (10) avec un corps métallique, comprenant :
une structure de saphir (11) comprenant une surface plane (11A) et pourvue d'une partie concave (12) sur la surface plane (11A), et
un corps métallique (20) disposé dans la partie concave (12) et relié à une surface intérieure (13) de la partie concave (12),
dans laquelle le corps métallique (20) comprend une partie de surface (20A) qui affleure sensiblement la surface plane (11A),
la structure de saphir étant **caractérisée en ce que** :
la surface intérieure (13) de la partie concave (12) comporte une surface inférieure (13α), une surface latérale (13β) et une surface inclinée (13γ) située entre la surface inférieure (13α) et la surface latérale (13β),
où la surface inclinée (13γ) est inclinée par rapport à la surface inférieure (13α) et à la surface latérale (13β),
où la surface inclinée (13γ) a une rugosité moyenne arithmétique supérieure à celle de la surface inférieure (13α) et de la surface latérale (13β).

2. Structure de saphir (10) avec un corps métallique selon la revendication 1, dans laquelle le corps métallique (20) contient de l'argent comme composant principal.

3. Structure de saphir (10) avec un corps métallique selon la revendication 2, dans laquelle le corps métallique (20) contient du dioxyde de silicium (SiO₂).

4. Structure de saphir (10) avec un corps métallique selon la revendication 2 ou 3, dans laquelle le corps métallique (20) contient du cuivre (Cu).

5. Structure de saphir (10) avec un corps métallique selon l'une quelconque des revendications 2 à 4, dans laquelle le corps métallique (20) contient du titane (Ti).

6. Structure de saphir (10) avec un corps métallique selon la revendication 5, dans laquelle le corps métallique (20) comprend une couche de liaison (22) contenant du titane (Ti) comme composant principal et formée dans une région de liaison qui est liée à la surface intérieure (13).

7. Structure de saphir (10) avec un corps métallique selon l'une quelconque des revendications 1 à 6, dans laquelle la structure de saphir (11) est un corps de type plaque utilisant la surface plane (11A) comme première surface, et comprend un trou traversant (15) avec des ouvertures sur une surface inférieure (13α) de la partie concave (12) et une seconde surface (11B) disposée sur le côté opposé à la première surface.

8. Structure de saphir (10) avec un corps métallique selon la revendication 7, comprenant en outre un conducteur traversant (17) formé d'un métal et remplissant le trou traversant (15).

9. Structure de saphir (10) avec un corps métallique selon l'une quelconque des revendications 1 à 8, dans laquelle une rugosité moyenne arithmétique (Ra) de la partie de surface (20A) du corps métallique (20) sensiblement à fleur de la surface plane (11A) est supérieure à la rugosité moyenne arithmétique (Ra) de la surface plane (11A).

10. Structure de saphir (10) avec un corps métallique selon l'une quelconque des revendications 1 à 9, dans laquelle la rugosité moyenne arithmétique de la surface plane (11A) est de 10 nm ou moins.

11. Structure de saphir (10) avec un corps métallique selon la revendication 6, dans laquelle la rugosité moyenne arithmétique de la surface plane (11A) est de 1 nm ou moins.

12. Procédé de fabrication d'une structure de saphir avec un corps métallique, comprenant les étapes suivantes consistant à :
former une partie concave (12) sur une surface plane (11A) en effectuant un traitement sur une partie de la surface plane (11A) d'une structure de saphir (11) comprenant la surface plane (11A),
appliquer une pâte métallique (19) contenant des particules métalliques (21) et un solvant (18) à l'intérieur de la partie concave formée (12),
former un corps métallique (20) disposé dans la partie concave (12) et lié à une surface intérieure (13) de la partie concave (12) en chauffant la structure de saphir (11) sur laquelle la pâte métallique (19) est appliquée pour évaporer le solvant (18) contenu dans la pâte métallique (19) et lier les particules métalliques (21) les unes aux autres, et
polir la surface plane (11A) et une surface du corps métallique (20),
dans lequel, pendant le polissage, au moins une partie de la surface du corps métallique (20) devient sensiblement à fleur de la surface plane (11A), en polissant la surface plane (11A) et la surface du corps métallique (20) en même temps,
le procédé étant **caractérisé en ce que** la surface intérieure (13) de la partie concave formée (12) a une surface inférieure (13a), une surface latérale (13β) et une surface inclinée (13γ) disposée entre la surface inférieure (13a) et la surface latérale (13β), où la surface inclinée (13γ) est inclinée par rapport à la surface inférieure (13a) et à la surface latérale (13β), où la surface inclinée (13γ) a une rugosité moyenne arithmétique supérieure à celle de la surface inférieure (13α) et de la surface latérale (13β).

13. Procédé de fabrication d'une structure de saphir avec un corps métallique selon la revendication 12,
dans lequel les particules métalliques (21) contiennent de l'argent comme composant principal et
la pâte métallique (19) contient du dioxyde de silicium.

14. Procédé de fabrication d'une structure de saphir avec un corps métallique selon la revendication 12 ou 13, dans lequel la pâte métallique (19) contient en outre des particules de cuivre.

15. Procédé de fabrication d'une structure de saphir avec un corps métallique selon l'une quelconque des revendications 12 à 14, dans lequel la pâte métallique (19) comprend en outre des particules de titane.

16. Procédé de fabrication d'une structure de saphir avec un corps métallique selon l'une quelconque des revendications 12 à 15,
dans lequel, pendent l'étape consistant à appliquer, la surface du corps métallique (20) disposé dans la partie concave (12) est positionnée plus près d'une surface inférieure (13α) de la partie concave (12) que de la surface plane (11A), et
l'étape consistant à polir comprend une première étape dans laquelle le corps métallique (20) n'est pas poli tandis que la surface plane (11A) est polie, et une seconde étape dans laquelle la surface plane (11A) et le corps métallique (20) sont polis simultanément.

17. Appareil électronique (101) comprenant :
un dispositif (201, 202), et
un corps extérieur (300) qui loge le dispositif (201, 202),
dans lequel une structure de saphir avec un corps métallique selon l'une quelconque des revendications 1 à 11 est utilisée pour au moins une partie du corps extérieur (300) .

18. Appareil électronique (101), comprenant :
un dispositif (510b, 500a, 500b), et
un corps de montage (600) sur lequel est disposé le dispositif (510b, 500a, 500b),
dans lequel une structure de saphir avec un corps métallique selon l'une quelconque des revendications 1 à 11 est utilisée pour au moins une partie du corps de montage (600) .

19. Corps extérieur (300), dans lequel le corps extérieur (300) est utilisé pour un appareil électronique (101) et est configuré en utilisant une structure de saphir avec un corps métallique selon l'une quelconque des revendications 1 à 11.
